Europäisches Patentamt

European Patent Office

Office européen des brevets

(11) Publication number: **0 055 552**
**B1**

# EUROPEAN PATENT SPECIFICATION

(45) Date of publication of patent specification: **11.03.87**

(21) Application number: **81305915.1**

(22) Date of filing: **17.12.81**

(51) Int. Cl.⁴: **H 01 L 23/56**, H 01 L 27/06, H 02 H 7/20, H 02 H 9/04, H 03 F 1/52

(54) Input protection circuit for an MIS transistor.

(30) Priority: **26.12.80 JP 186868/80**

(43) Date of publication of application:
**07.07.82 Bulletin 82/27**

(45) Publication of the grant of the patent:
**11.03.87 Bulletin 87/11**

(84) Designated Contracting States:
**DE FR GB**

(56) References cited:
**US-A-3 636 385**
**US-A-4 061 928**

(73) Proprietor: **FUJITSU LIMITED**
**1015, Kamikodanaka Nakahara-ku**
**Kawasaki-shi Kanagawa 211 (JP)**

(72) Inventor: **Taira, Shigenobu**
**310-5, Aza Fujiwara Oaza Kamega Ikkimachi**
**Aizuwakamatsu-shi Fukushima 965 (JP)**

(74) Representative: **Sunderland, James Harry et al**
**HASELTINE LAKE & CO Hazlitt House**
**28 Southampton Buildings Chancery Lane**
**London WC2A 1AT (GB)**

Courier Press, Leamington Spa, England.

# Description

The present invention relates to an input protection circuit for an MIS transistor.

In a semiconductor integrated circuit comprising an MIS transistor, the gate of the MIS transistor may be connected to an input terminal. The insulating film between the gate electrode of such an MIS transistor and the substrate of the IC is very thin. If an excessive voltage is applied to the gate electrode of the transistor, from the input terminal, gate breakdown, for example a short-circuit between the gate and the source of the transistor, will occur.

Undesirable excessive voltages are likely to be applied to such an IC during handling of the IC in a manufacturing process. Static charges, which can result in the application of excessive voltages, are particularly likely to arise during handling by personnel.

It is virtually impossible to provide an environment free of static charges, and for this reason an integrated circuit using MIS transistors is usually provided with an input protection circuit connected to the input terminal of the IC.

A previously proposed input protection circuit comprises a resistor and a protection transistor. The resistor is connected between the input terminal and the gate of an MIS transistor to be protected, and the drain of the protection transistor is connected to the gate of the MIS transistor to be protected, whilst the source of the protection transistor is connected to a ground line. Such a protection transistor is known as a field transistor and has a thicker gate insulating film than that of ordinary MIS transistors in the IC and is the same as an NPN lateral transistor (drain (N)—channel (P)—source (N)). The breakdown voltage of this protection transistor is determined by the breakdown voltage of the PN junction between its drain and channel.

US—A—4 061 928 discloses a circuit arrangement for the protection of inputs of integrated MOS circuits against excessive voltages.

First and second high-ohmic compensating resistances are connected in series between an input terminal and a main circuit MOS transistor. First protection means, comprising a first transistor, having a first breakdown voltage, are connected between a power supply line and a first connecting point, at which the first and second resistances are connected to one another. Second protection means, comprising a second transistor, having a second breakdown voltage, lower than the main breakdown voltage of the main circuit transistor, are connected between a power supply line and a second connecting point, at which the second resistance and the main circuit transistor are connected to one another.

Efforts are continually being made to realise higher integration density for integrated circuits, and the greater the integration density the thinner the gate insulating film of an MIS transistor, and the lower the gate breakdown voltage. If the gate breakdown voltage becomes lower than that (PN junction breakdown voltage) of the protection transistor, the protection transistor is ineffective to provide a protection function.

According to the present invention there is provided an input protection circuit, formed on a substrate, connected to a main circuit MIS transistor to be protected from the application of high voltage thereto, comprising:

first and second impedance elements connected in series between an input terminal and the main circuit MIS transistor;

first protection means, comprising a first transistor having a first breakdown voltage, connected between a first power supply line and a first connecting point, at which the first and second impedance elements are connected to one another; and

second protection means comprising a second transistor, having a second breakdown voltage, lower than the main gate breakdown voltage of the main circuit MIS transistor, connected between the said first power supply line or a second power supply line and a second connecting point, at which the second impedance element and the main circuit MIS transistor are connected to one another;

characterised in that the first breakdown voltage which is the PN junction breakdown voltage of the first transistor is higher than the said main gate breakdown voltage, and the first transistor has a first mutual conductance, and the second transistor has a second mutual conductance, lower than the first mutual conductance.

An embodiment of the present invention prevents the application of an excessive voltage, arising from a static charge for example, to the gate of an MIS (Metal-Insulator-Semiconductor) type transistor provided on the surface of a semiconductor substrate.

An embodiment of the present invention can provide an input protection circuit for preventing the application of an unwanted excessive voltage to an MIS transistor.

An embodiment of the present invention can provide an input protection circuit for protecting the MIS transistor from gate breakdown, such as could occur if an unwanted excessive voltage were applied to the gate of an MIS transistor having a thin gate insulation film.

Reference is made, by way of example, to the accompanying drawings, in which:—

Figure 1 is a schematic sectional view of a previously proposed input protection circuit,

Figure 2 is an illustration of a circuit equivalent to the protection circuit of Figure 1,

Figure 3 is a graph for assistance in explanation of operation of the circuit of Figures 1 and 2,

Figure 4 is a schematic block diagram of an embodiment of the present invention,

Figure 5 is a schematic block diagram of another embodiment of the present invention,

Figure 6 is a sectional view of an input protection circuit embodying the present invention,

Figure 7 illustrates an equivalent circuit of the input protection circuit shown in Figure 6,

Figure 8 is a graph for assistance in explanation of operation of the embodiment of Figures 6 and 7, and

Figure 9 illustrates an equivalent circuit of another input protection circuit embodying the present invention.

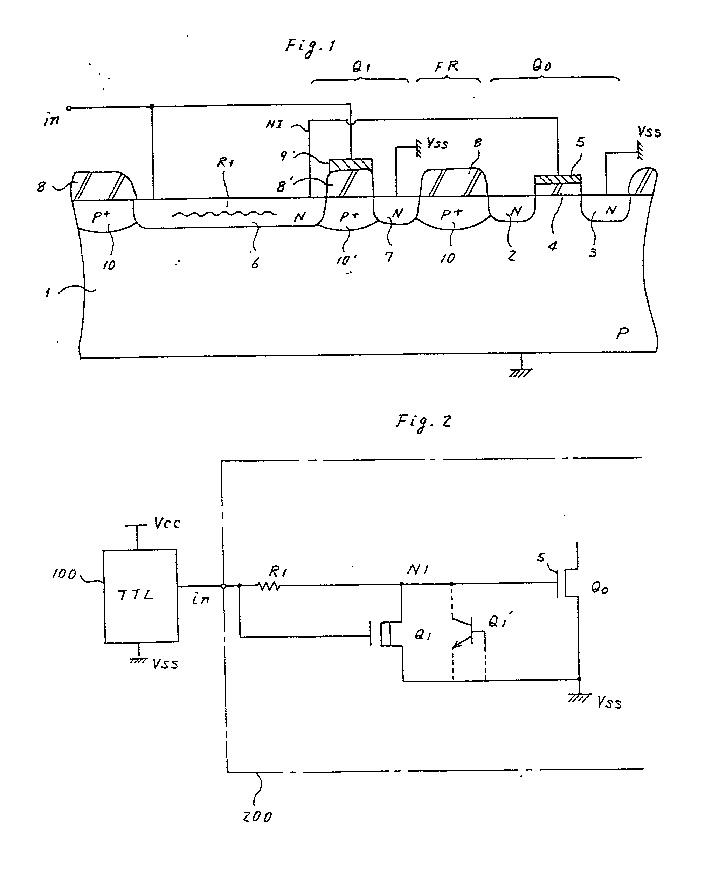

Figure 1 is a sectional view illustrative of the structure of an MIS transistor and a previously proposed input protection circuit for protecting the gate of that MIS transistor, and Figure 2 illustrates an equivalent circuit of the circuit shown in Figure 1. In Figure 1, 1 is a P type semiconductor substrate. An MIS type transistor $Q_0$ formed on the substrate and comprising N type drain 2, source 3, gate insulating film 4 and gate electrode 5 is to be protected. The gate electrode 5 is connected to an input terminal *in* and a protection circuit is provided which consists of an impedance element, a resistor $R_1$, and a protection transistor $Q_1$ between the gate electrode 5 and the input terminal *in*.

The resistor $R_1$ consists of an N type diffusion layer 6 and the protection transistor $Q_1$ is a field transistor comprising a thick insulating film 8', which is the same thickness as (field) insulating film 8 provided in other parts FR of the field, and an electrode 9 formed thereon, with the N type diffusion layer 6 functioning as a drain and a diffusion layer 7 functioning as a source. $P^+$ regions 10, having a higher impurity concentration than is provided in general in the substrate, for the channel cut under the field insulating film 8 and a $P^+$ region 10' is also provided in respect of the field transistor $Q_1$.

The input terminal *in* will generally be connected to an external TTL circuit, as indicated at 100 in Figure 2. In Figure 2, those parts surrounded by the chain line constitute a semiconductor integrated circuit 200 having a protection transistor.

The protection circuit is provided for protecting the gate of transistor $Q_0$ from breakdown when an excessively high voltage is applied to the input terminal *in*. Such an excessively high voltage may result from static charge generated by working personnel. In the circumstances in which such a static charge can give rise to the application of an excessively high voltage the device 200 will not be connected to the TTL circuit 100 etc.

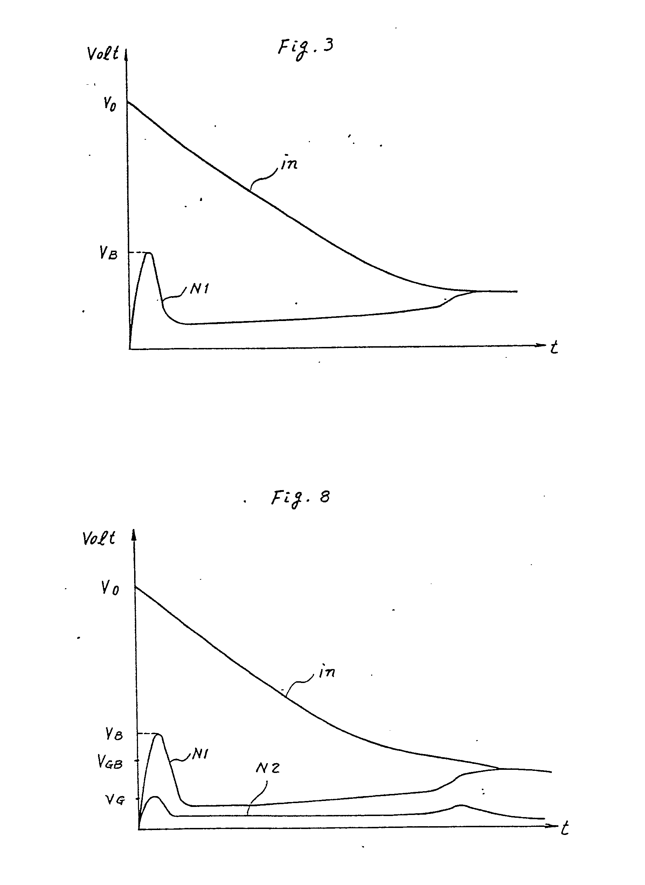

A protecting operation for protection from an excessively high voltage applied to the input terminal *in* will be explained with reference to the graph of Figure 3, in which potentials at the input terminal *in* and at a point N1, shown in Figure 2, are indicated.

When an excessively high voltage $V_0$ is applied to the input terminal *in*, the voltage of the terminal N1 (the voltage to be applied to the gate 5) is immediately increased as a consequence. When the potential of terminal point N1 exceeds the breakdown voltage $V_B$ of the protection transistor $Q_1$, which is a field transistor, the transistor $Q_1$ turns ON, providing a conductive path between the terminal N1 and a ground line $V_{ss}$. As a result, an excessively high voltage applied to the input terminal *in* is absorbed by the ground side via the transistor $Q_1$ and the potential of terminal N1 falls, as shown in Figure 3. The potential of input terminal *in* also falls as shown in Figure 3, and the transistor $Q_1$ turns OFF and returns to ordinary operation. In ordinary operation, only a signal of a level such as the external TTL level is applied to the input terminal *in*, and therefore the voltage applied to the gate 5 does not become higher than the breakdown voltage of the protection transistor $Q_1$, and the transistor $Q_1$ is always OFF.

This protection transistor $Q_1$ is a field transistor but a parasitic NPN lateral transistor $Q_1'$ actually operates. The breakdown voltage $V_B$ is therefore equal to the PN junction breakdown voltage between the $P^+$ type layer 10' and the N type diffusion layer 6. When the transistor $Q_1$ turns ON, it absorbs a large amount of charge because its mutual conductance gm is sufficiently large.

In a case in which the gate insulating film (oxide film) 4 of the MIS transistor $Q_0$ is as thick as about 1000 Å (100 nm), the gate breakdown voltage is as high as about 80 V. On the other hand, the impurity concentration of the $P^+$ type layer 10' is limited because this layer is formed by the same process as that used for forming the $P^+$ type layer 10 for the channel cut, and the breakdown voltage $V_B$, which is equal to the breakdown voltage of the protection circuit, is fixed, for example, at a value of about 35 V. In a case in which the gate breakdown voltage is as high as 80 V, the protection circuit of Figures 1 and 2 has an adequate function. However, in recent times, higher integration densities for the elements of an integrated circuit have required the use of a gate insulating film 4 of a thickness of as little as 400 Å (40 nm) and as a result the gate breakdown voltage is reduced to as little as about 30 to 35 V. In such a case, a protection transistor having a breakdown voltage of 35 V no longer provides an adequate protection function. Of course, it is possible to reduce the breakdown voltage $V_B$ by controlling the concentration of the $P^+$ layer 10' separately from that of the $P^+$ 10 for channel cut. To do this, however, a special injection process using a special mask is required, and this is not very practical.

An input protection circuit embodying the present invention can protect a transistor $Q_0$ to be protected even if the gate breakdown voltage $(V_{GB})$ of that transistor is lower than the breakdown voltage of transistor $Q_1$.

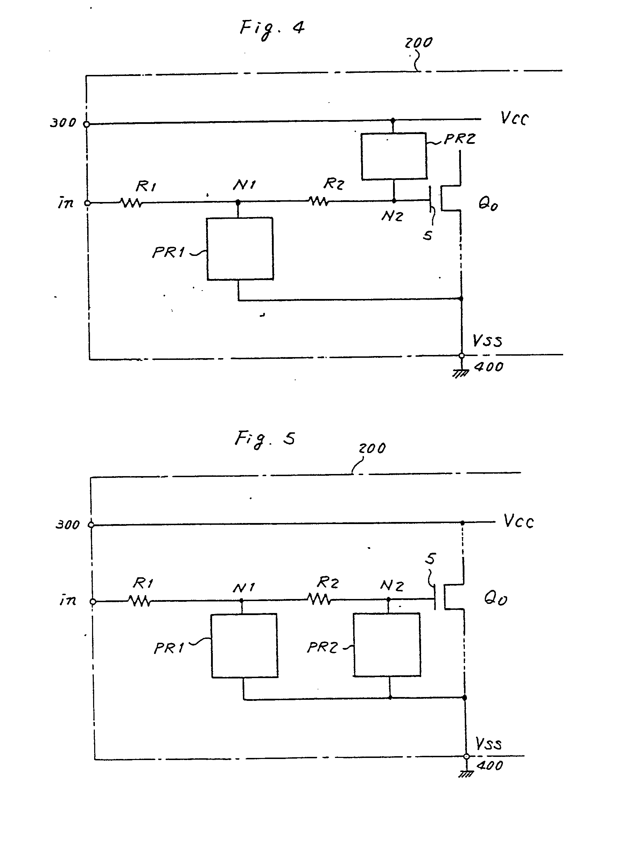

Figure 5 illustrates an embodiment of the present invention. Gate 5 of a transistor $Q_0$ to be protected, provided in an integrated circuit 200, is connected to an input terminal *in* via a resistor $R_1$ which is a first impedance element and a resistor $R_2$ which is a second impedance element. 300 is a high voltage power supply terminal and 400 is a lower voltage power supply terminal, that is, a ground terminal. First protection means PR1 is connected between a first connecting point N1 and a power supply terminal (400) whilst second protection means PR2 is connected between a second connecting point N2 and the power supply terminal (400) respectively.

The first protection means PR1 has a high breakdown voltage but presents a small impedance Z1 when it is turned ON and is capable of passing a large amount of excessive static charge, applied to the input terminal, to ground power supply $V_{ss}$ (400).

The second protection means PR2 has a large impedance Z2 when it is turned ON and cannot absorb a large amount of static charge, but has a breakdown voltage which is lower than a gate breakdown voltage $V_{GB}$ of the transistor $Q_0$ by a sufficient amount. Therefore, the second protection means can compensate for the disadvantage that the first protection means PR1 has a high breakdown voltage.

Figure 4 illustrates an embodiment of the present invention in which the second protection means PR2 is connected to the high power supply $V_{cc}$ (terminal 300). In Figure 5, of course, the second protection means PR2 is connected to the ground power supply $V_{ss}$ (terminal 400).

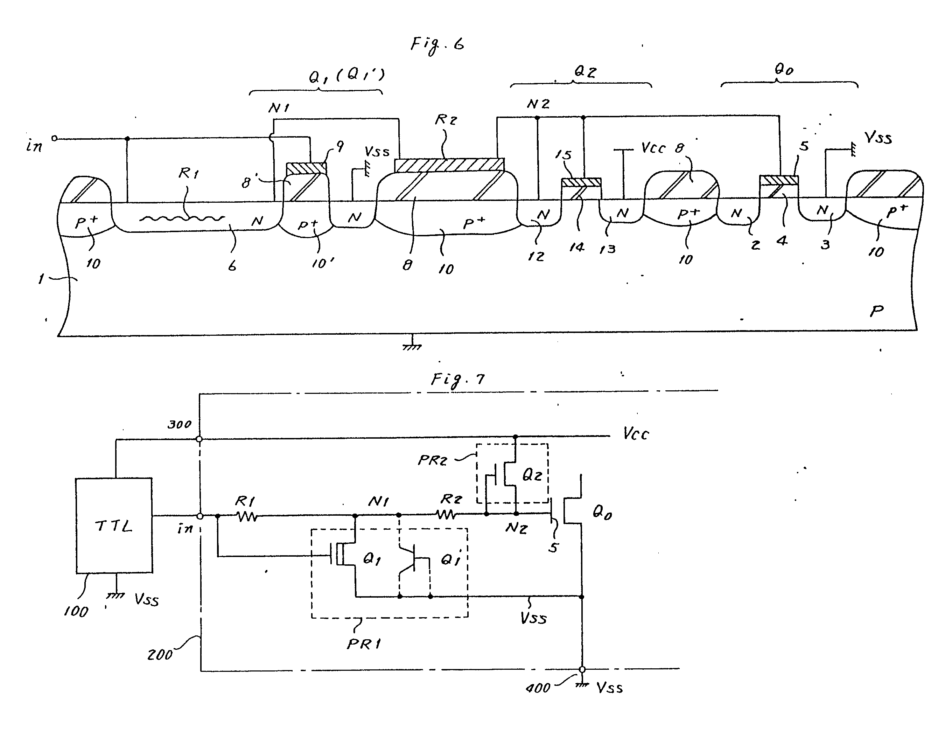

Figure 6 is a sectional view of a practical form of an input protection circuit embodying the present invention, whilst Figure 7 shows an equivalent circuit of Figure 6. In Figures 6 and 7 the same reference characters as are used in Figures 1 and 2 indicate similar items.

In the embodiment of Figures 6 and 7, first and second resistors $R_1$, $R_2$ are connected in series between the gate electrode 5 of the MIS transistors $Q_0$ to be protected and the input terminal *in*. A first protection transistor $Q_1$ is provided between the first connecting point N1 and the ground power supply $V_{ss}$, whilst a second protection transistor $Q_2$ is provided between a second connecting point N2 and the high power supply $V_{cc}$.

The structures of the first resistor $R_1$ and the first protection transistor $Q_1$ in Figure 6 are the same as the structures shown in Figures 1 and 2. The second resistor $R_2$ comprises a polycrystalline silicon layer, whilst the second protection transistor $Q_2$ has the same structure and characteristics as those of the main circuit MIS transistor $Q_0$ to be protected and is provided within the integrated circuit device 200.

The breakdown voltage $V_B$ of the transistor $Q_1$ is equal to the PN junction breakdown voltage (about 35 V) between the drain region 6 and channel region 10'. The breakdown voltage of transistor $Q_2$ is equal to the threshold voltage $V_{th}$ of the MIS transistor. This is because the power supply terminals 300, 400 (for $V_{cc}$, $V_{ss}$) are in floating condition when the IC is being handled during the manufacturing process and the potentials thereof are usually 0 V (ground level).

The impurity concentration of the drain and source regions of transistor $Q_1$ may be the same as that of the drain or source region of transistor $Q_0$.

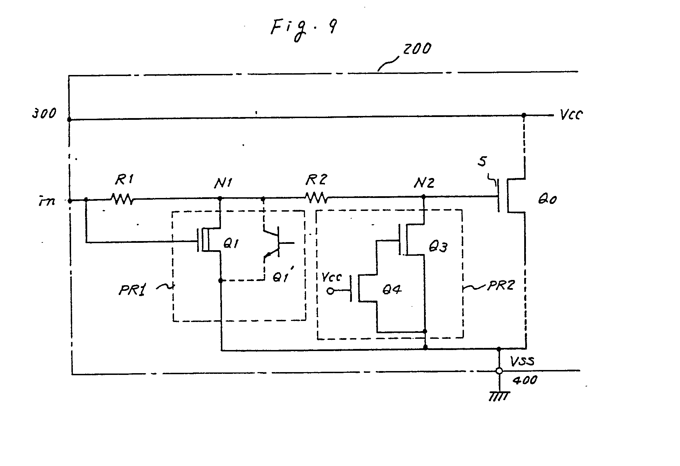

The operation of the input protection circuit according to the embodiment of Figures 6 and 7 is explained in detail with reference to the graph of Figure 8. $V_0$ is an excessive voltage applied to the input terminal *in*; $V_B$ is the breakdown voltage of transistor $Q_1$; $V_G$ is the maximum voltage level to be applied to the gate of transistors $Q_2$ and $Q_0$; $V_{GB}$ is the gate breakdown voltage of transistor $Q_0$ to be protected; *in* is the potential of the input terminal *in*; and N1, N2 are the potentials of the first and second connecting points.

When an excessively high voltage $V_0$, for example, 500 to 1000 volts, is applied momentarily to the input terminal *in*, the potentials of the first and second connecting points N1, N2 increase immediately. When the potential of the second connecting point N2 exceeds the breakdown voltage of transistor $Q_2$ (a threshold voltage of about 1 V), the transistor $Q_2$ turns ON. The mutual conductance gm of the transistor $Q_2$ is small but the ON resistance Z2 of $Q_2$ is large as compared with that of the field transistor $Q_1$. Therefore, a minute current (several mA) flows into the transistor $Q_2$ and $Q_2$ cannot absorb a large amount of static charge. However, the potentials of the connecting points N1, N2 become equal to levels divided from $V_0$ by a resistor determined by the resistors $R_1$, $R_2$ and $\rho$ of the transistor $Q_2$ (that is, $R_1$, $R_2$ and the transistor $Q_2$ act as potential dividers and the levels of N1 and N2 are determined by division of the input potential $V_0$). Therefore, the potential level of the connecting point $N_2$ is $V_G$, even at most, and does not exceed the gate breakdown voltage $V_{GB}$ (20 to 30 V) before the transistor $Q_1$ turns ON.

After a while, the transistor $Q_1$ turns ON when the potential level of the connecting point N1 becomes higher than $V_B$, allowing a heavy current (several A) to flow and thereby a large amount of static charge is absorbed. Therefore, the gate 5 is kept at a level below (or not more than) the voltage $V_G$ which is lower than the gate breakdown voltage $V_{GB}$, and thereby gate breakdown can be prevented.

If the transistor $Q_1$ were not provided, the potential of the connecting point N2 would increase to more than $V_G$ because the mutual conductance gm of $Q_2$ is small, that is, the impedance Z2 is large even when the transistor $Q_2$ is turned ON, and after a while potential would exceed the gate breakdown voltage $V_{GB}$ resulting in gate breakdown at the transistor $Q_0$.

The second protection transistor $Q_2$ does not turn ON during ordinary operations, thereby avoiding any problems. Since only a level less than $V_{cc}$, as low as the TTL logic level, is applied to the input terminal *in* in normal operation, the gate of transistor $Q_2$ is always at a lower potential than the power supply line $V_{cc}$ of the source and is at the same level as the drain. As a result, the second protection transistor $Q_2$ does not turn ON.

A practical design example is indicated below. When $V_B$=35 V and $R_2$=500 ohms a current flowing when the transistor $Q_2$ turns ON when $V_G$ is applied to the gate of that transistor is taken to be 50 mA, and a voltage drop across the resistor $R_2$ to be 25 V (500 ohms×0.05 A=25 V). Therefore, $V_G$=35 V−25 V=10 V. Moreover, $Q_2$ is designed in

accordance with the following equations so that $V_G$ becomes 10 V, whilst $I_D$ becomes 50 mA:—

$$I_D = \beta/2(V_G - V_{th})^2$$

Where $I_D$ is a drain current, and $V_{th}$ is a threshold voltage.

Therefore, if $V_{th}$ is 1.0 V,

$$\beta = 1234 \; \mu A/V^2$$

As for the size of $Q_2$ required to provide such a characteristic, the relationship between the channel width W and channel length L is as follows, with the film thickness of the insulating film taken to be 400 Å (40 nm)

$$W/L = 60 \; \mu/3 \; \mu$$

This value is almost the same as that of an ordinary MIS transistor.

Figure 9 is a schematic diagram of another embodiment of the present invention. In the embodiment of Figure 9, second protection means PR2 is provided between second connecting point N2 and ground power supply $V_{ss}$ (400). The second protection means PR2 comprises a second protection transistor $Q_3$ having a drain which is connected to the connecting point N2, a source which is connected to the ground power supply and a gate which is connected to the ground power supply via a transistor $Q_4$.

Since high power supply voltage $V_{cc}$ is normally about 0 V during handling in the course of the manufacturing process, the transistor $Q_4$ is always in the OFF condition. When an excessively high voltage $V_0$ is applied to the input terminal *in* and the level at the second connecting point N2 rises, the gate potential of transistor $Q_3$ increases due to capacitive coupling between the drain and gate. After a while, when the potential between the gate and source (ground) exceeds the threshold voltage, the transistor $Q_3$ turns ON. Therefore, the breakdown voltage of the second protection means PR2 is almost equal to the threshold voltage of the transistors $Q_3$. The transistors $Q_3$ and $Q_4$ provide the same structure and characteristics as those of the MIS transistor of the main circuit in the device 200.

Even when the transistor $Q_3$ turns ON, current flowing therein is low level and sufficient static charge cannot be absorbed thereby and therefore the level of N2 tends to increase. When the transistor $Q_1$ turns ON, a large amount of static charge is absorbed and the level of connecting point N2, namely the gate voltage of the transistor $Q_0$ is kept at a value lower than $V_G$ which is also lower than the gate breakdown voltage $V_{GB}$.

As explained above, an embodiment of the present invention provides an input protection circuit which can effectively prevent the gate of an MIS transistor, comprising a minute and thin gate insulating film, from breakdown. Moreover, an input protection circuit embodying the present invention can be simply realised without additions or modifications to the manufacturing process.

An embodiment of the present invention provides an input protection circuit which prevents breakdown of the gate of an MIS transistor due to excessively high voltage. An input protection circuit embodying the present invention comprises a first resistor and a second resistor connected in series between an input terminal and the gate of the transistor to be protected. A first protection transistor is provided between a first connecting point, between the first and second resistors, and a ground power supply, and a second protection transistor is provided between a second connecting point, between the second resistor and the gate of the transistor to be protected, and a $V_{cc}$ power supply. The first protection transistor has a large mutual conductance gm, whilst the second protection transistor has a low breakdown voltage. With an input protection circuit embodying the present invention, even when the gate breakdown voltage of the transistor to be protected is lower than the breakdown voltage of the first protection transistor, the gate voltage of the transistor to be protected is kept at a voltage lower than the gate breakdown voltage by means of the second protection transistor having a lower breakdown voltage.

**Claims**

1. An input protection circuit, formed on a substrate (1), connected to a main circuit MIS transistor (Q0) to be protected from the application of high voltage thereto, comprising:

first (R1) and second (R2) impedance elements connected in series between an input terminal (in) and the main circuit MIS transistor (Q0);

first protection means (PR1), comprising a first transistor (Q1), having a first breakdown voltage, connected between a first power supply line Vss) and a first connecting point (N1), at which the first (R1) and second (R2) impedance elements are connected to one another; and

second protection means (PR2), comprising a second transistor (Q2; Q3), having a second breakdown voltage, lower than the main gate breakdown voltage of the main circuit MIS transistor (Q0), connected between the said first power supply line (Vss), or a second power supply line (Vcc) and a second connecting point (N2), at which the second impedance element (R2) and the main circuit MIS transistor (Q0) are connected to one another;

characterised in that the first breakdown voltage which is the PN junction breakdown voltage of the first transistor is higher than the said main gate breakdown voltage, and the first transistor (Q1) has a first mutual conductance, and the second transistor (Q2; Q3) has a second mutual conductance, lower than the first mutual conductance.

2. An input protection circuit as claimed in claim 1, wherein the main circuit MIS transistor (Q0)

comprises a gate connected to the said input terminal (in) via the first (R1) and second (R2) impedance elements.

3. An input protection circuit as claimed in claim 1 or 2, wherein the second impedance element (R2) has a predetermined impedance value such that a potential at the said second connecting point (N2) is lower than the said main breakdown voltage when the second protection means (PR2) is turned ON.

4. An input protection circuit as claimed in any preceding claim, wherein the first transistor (Q1) comprises:

a first diffusion region (6) formed in the substrate (1) and connected to the first connecting point (N1);

a channel region (10'), the impurity type of which is opposite to that of the first diffusion region (6), formed in the substrate (1) contiguously with the first diffusion region (6); and

a second diffusion region, the impurity type of which is the same as that of the first diffusion region (6), formed in the substrate (1) contiguously with the channel region, and connected to a ground power supply line (Vss); wherein impurity concentration of the first (6) and second diffusion regions is the same as that of a drain or source region of the main circuit MIS transistor (Q0).

5. An input protection circuit as claimed in any preceding claim, wherein the second transistor (Q2) comprises:

a source or drain region (12) connected to the second connecting point (N2);

a drain or source region (13) connected to a high voltage power supply line (Vcc); and

a gate (15) connected to the second connecting point (N2); wherein

the breakdown voltage of the second transistor (Q2) is the same as the threshold of the main circuit MIS transistor (Q0).

6. An input protection circuit as claimed in any one of the claims 1 to 4, wherein the second transistor (Q3) comprises:

a source or drain region connected to the second connecting point (N2); and

a drain or source region connected to a ground power supply line (Vss); wherein

threshold voltage of the second transistor (Q3) is the same as that of the main circuit MIS transistor (Q0).

7. A input protection circuit as claimed in any preceding claim, wherein the first impedance element (R1) comprises a diffusion region (6) formed in the substrate (1).

8. An input protection circuit as claimed in any preceding claim, wherein the second impedance element (R2) comprises polycrystalline silicon.

**Patentansprüche**

1. Eingangsschutzschaltung, gebildet auf einem Substrat (1), die mit einem Hauptschaltungs-MIS-Transistor (Q0) verbunden ist, der von der Zuführung einer hohen Spannung geschützt werden soll, mit:·

ersten (R1) und zweiten (R2) Impedanzelementen, die in Reihe zwischen einem Eingangsanschluß (in) und dem Hauptschaltungs-MIS-Transistor (Q0) angeschlossen sind;

einer ersten Schutzeinrichtung (PR1), die einen ersten Transistor (Q1), mit einer ersten Durchbruchsspannung, umfaßt, die zwischen einer ersten Energieversorgungsleitung (Vss) und einem ersten Anschlußpunkt (N1) angeschlossen ist, bei welchem die ersten (R1), und zweiten (R2) Impedanzelemente miteinander verbunden sind; und

einer zweiten Schutzeinrichtung (PR2), die einen zweiten Transistor (Q2; Q3), mit einer zweiten Durchbruchsspannung, die niedriger als die Hauptgatedurchbruchsspannung des Hauptschaltungs-MIS-Transistors (Q0) ist, umfaßt, die zwischen der genannten ersten Energieversorgungsleitung (Vss) oder einer zweiten Energieversorgungsleitung (Vcc) und einem zweiten Anschlußpunkt (N2) angeschlossen ist, bei welchem das zweite Impedanzelement (R2) und der Hauptschaltungs-MIS-Transistor (Q0) miteinander verbunden sind;

dadurch gekennzeichnet, daß die erste Durchbruchsspannung, welche die Durchbruchsspannung des PN-Übergangs des ersten Transistors ist, höher als die genannte Hauptgatedurchbruchsspannung ist, und der erste Transistor (Q1) eine erste gemeinsame Konduktanz hat und der zweite Transistor (Q2; Q3) eine zweite gemeinsame Konduktanz hat, welche niedriger als die erste gemeinsame Konduktanz ist.

2. Eingangsschutzschaltung nach Anspruch 1, bei welcher der Hauptschaltungs-MIS-Transistor (Q0) ein Gate umfaßt, das mit dem genannten Eingangsanschluß (in) über die ersten (R1) und zweiten (R2) Impedanzelemente verbunden ist.

3. Eingangsschutzschaltung nach Anspruch 1 oder 2, bei welcher das zweite Impedanzelement (R2) einen vorbestimmten Impedanzwert hat, so daß ein Potential bei dem genannten zweiten Anschlußpunkt (N2) niedriger als die genannte Hauptdurchbruchsspannung ist, wenn die zweite Schutzeinrichtung (PR2) auf EIN geschaltet ist.

4. Eingangsschutzschaltung nach einem der vorhergehenden Ansprüche, bei welcher der erste Transistor (Q1) umfaßt:

einen ersten Diffusionsbereich (6), der in dem Substrat (1) gebildet und mit dem ersten Anschlußpunkt (N1) verbunden ist;

einen Kanalbereich (10'), dessen Verunreinigungstyp entgegengesetzt zu demjenigen des ersten Diffusionsbereichs (6) ist, und der in dem Substrat (1) an den ersten Diffusionsbereich (6) angrenzend ausgebildet ist; und

einen zweiten Diffusionsbereich, dessen Verunreinigungstyp der gleiche wie derjenige des ersten Diffusionsbereichs (6) ist und der in dem Substrat (1) an den Kanalbereich angrenzend ausgebildet und mit einer Erdenenergieversorgungsleitung (Vss) verbunden ist; wobei die Verunreinigungskonzentration des ersten (6) und zweiten Diffusionsbereichs dieselbe wie diejenige eines Drain- oder Sourcebereiches des Hauptschaltungs-MIS-Transistors (Q0) ist.

5. Eingangsschutzschaltung nach einem der vorhergehenden Ansprüche, bei welcher der zweite Transistor (Q2) umfaßt:

einen Source- oder Drainbereich (12), der mit dem zweiten Anschlußpunkt (N2) verbunden ist;

einen Drain- oder Sourcebereich (13), der mit einer Energieversorgungsleitung (Vcc) hoher Spannung verbunden ist; und

ein Gate (15), das mit dem zweiten Anschlußpunkt (n2) verbunden ist; bei welcher

die Durchbruchsspannung des zweiten Transistors (Q2) dieselbe wie die Schwellenwertspannung des Hauptschaltungs-MIS-Transistors (Q0) ist.

6. Eingangsschutzschaltung nach einem der Ansprüche 1 bis 4, bei welcher der zweite Transistor (Q3) umfaßt:

einen Source- oder Drainbereich, der mit dem zweiten Anschlußpunkt (N2) verbunden ist; und

einen Drain- oder Sourcebereich, der mit einer Erdenergieversorgungsleitung (Vss) verbunden ist; bei welcher

die Schwellenwertspannung des zweiten Transistors (Q3) dieselbe wie diejenige des Hauptschaltungs-MIS-Transistors (Q0) ist.

7. Eingangsschutzschaltung nach einem der vorhergehenden Ansprüche, bei welcher das erste Impedanzelement (R1) einen Diffusionsbereich (6) umfaßt, der in dem Substrat (1) gebildet ist.

8. Eingangsschutzschaltung nach einem der vorhergehenden Ansprüche, bei welcher das zweite Impedanzelement (R2) polykristallines Silizium umfaßt.

## Revendications

1. Circuit de protection d'entrée, formé sur un substrat (1), connecté à un transistor MIS d'un circuit principal (Q0) à protéger de l'application d'une haute tension, comprenant:

des premier (R1) et second (R2) éléments d'impédance connectés en série entre une borne d'entrée (IN) et le transistor MIS du circuit principal (Q0);

un premier moyen de protection (PR1), comprenant un premier transistor (Q1) ayant une première tension de claquage connecté entre une première ligne d'alimentation (VSS) et un premier point de connexion (N1), auquel les premier (R1) et second (R2) éléments d'impédance sont connectés l'un à l'autre;

un second moyen de protection (PR2), comprenant un second transistor (Q2; Q3) ayant une second tension de claquage inférieure à la tension de claquage de grille principale du transistor MIS (Q0) du circuit principal connecté entre la première ligne d'alimentation (Vss) ou une seconde ligne d'alimentation (Vcc) et un second point de connexion (N2), au niveau duquel le second élément d'impédance (R2) et le transistor is (Q0) du circuit principal sont connectés l'une à l'autre;

caractérisé en ce que la première tension de claquage qui est la tension de claquage de jonction PN du premier transistor est supérieure à la tension de claquage de grille principale, et en ce que le premier transistor (Q1) a une première conductance et que le second transistor (Q2; Q3) a une seconde conductance inférieure à la première conductance.

2. Circuit de protection d'entrée selon la revendication 1, dans lequel le transistor MIS (Q0) du circuit principal comprend une grille connectée à la borne d'entrée (IN) par l'intermédiaire des premier (R1) et second (R2) éléments d'impédance.

3. Circuit de protection d'entrée selon l'une des revendications 1 ou 2, dans lequel le second élément d'impédance (R2) a une valeur d'impédance prédéterminée de sorte que le potentiel au niveau du second point de connexion (N2) est inférieur à la tension de claquage principale quand le second moyen de protection (PR2) est rendu passant.

4. Circuit de protection d'entrée selon l'une quelconque des revendications précédentes, dans lequel le premier transistor (Q1) comprend:

une première région de diffusion (6) formé dans le substrat (1) et connectée au premier point de connexion (N1);

une région de canal (10'), dont le type d'impureté est opposé à celui de la première région de diffusion (6) formée dans le substrat (1) de façon contiguë à la première région de diffusion (6); et

une seconde région de diffusion, dont le type d'impureté est le même qui celui de la première région de diffusion (6) formée dans le substrat (1) de façon contiguë à la région de canal, et connectée à une ligne d'alimentation de masse (Vss); dans lequel:

la concentration en impuretés des première (6) et seconde régions de diffusion est la même que celle d'une région de source ou de drain du transistor MIS (Q0) du circuit principal.

5. Circuit de protection d'entrée selon l'une quelconque des revendications précédentes, dans lequel le second transistor (Q2) comprend:

une région de source ou de drain (12) connectée au second point de connexion (N2);

une région de drain ou de source (13) connectée à une ligne d'alimentation haute tension (VCC); et

une grille (15) connectée au second point de connexion (N2); dans lequel:

la tension de claquage du second transistor (Q2) est la même que le seuil du transistor MIS (Q0) du circuit principal.

6. Circuit de protection d'entrée selon l'une quelconque des revendications 1 à 4, dans lequel le second transistor (Q3) comprend:

une région de source ou de drain connectée au second point de connexion (N2); et

une région de drain ou de source connectée à une ligne d'alimentation de masse (Vss); dans lequel:

la tension de seuil du second transistor (Q3) est la même que celle du transistor MIS (Q0) du circuit principal.

7. Circuit de protection d'entrée selon l'une quelconque des revendications précédentes, dans lequel le premier élément d'impédance (R1) comprend une région de diffusion (6) formée dans le substrat (1).

8. Circuit de protection d'entrée selon l'une quelconque des revendications précédentes, dans lequel le second élément d'impédance (R2) comprend du silicium polycristallin.

8

Fig. 1

Q1    FR    Q0

Fig. 2

Fig. 3

Fig. 8

# Fig. 4

# Fig. 5

Fig. 6

$Q_1 (Q_1')$          $Q_2$          $Q_0$

$N1$          $R_2$          $N2$

in          9     Vss               Vcc 8          5     Vss

$R_1$     8'          $N$     $N$          15          $N$          $P^+$     $N$     $N$

$P^+$          $N$     $P^+$          $P^+$          $N$          $N$     $P^+$     $N$     $N$          $P^+$

10     6     10'     8     10     12     14 13     10     2 4 3     10

1          P

Fig. 7

300          Vcc

PR2          $Q_2$

$R_1$     $N1$     $R_2$

TTL     in               $Q_0$

$N2$

$Q_1$     $Q_1'$     5

100     Vss          Vss

PR1

200

400     Vss

0 055 552

$Fig \cdot 9$